# EUROPEAN PATENT APPLICATION

(11) **EP 4 492 693 A1**
(43) Date of publication of application: **15.01.2025**
(21) Application number: 23184579.3
(22) Date of filing: 11.07.2023
(51) Int. Cl.: H04B 1/10, H04B 17/29, H03G 3/20

(54) **SYSTEM AND METHOD FOR OVERLOAD DETECTION AND PREVENTION IN RADIO SPECTRUM MONITORING**

(71) Applicant: Rohde & Schwarz GmbH & Co. KG, 81671 München (DE)
(72) Inventor: Hisch, Martin, 85661 Forstinning (DE)
(74) Representative: Rupp, Christian

(57) **Abstract**

Disclosed is a system (1) for overload detection and prevention in radio spectrum monitoring. The system comprises an antenna (11), adapted to capture a wideband signal; a first wideband receiver (13); a second wideband receiver (14); and a power splitter (12), adapted to supply the captured wideband signal to the first wideband receiver (13) and to the second wideband receiver (14). The first wideband receiver (13) is adapted to periodically scan the supplied wideband signal for a highest signal power level and an associated frequency, and to periodically broadcast the highest signal power level and the associated frequency over a packet-switched network (15). The second wideband receiver (14) is adapted to receive the highest signal power level and the associated frequency over the packet-switched network (15), to attenuate the supplied wideband signal in accordance with the highest signal power level, the associated frequency, and a limiting signal power level of the wideband receivers (13, 14), and to receive the attenuated wideband signal. This avoids false detections in radio spectrum monitoring.

## Description

### Technical Field

The present disclosure relates generally to the field of radio spectrum monitoring, and to systems and methods for overload detection and prevention in the very field.

### Background Art

In radio spectrum monitoring systems, excessive receive power levels may lead to generation of mixing/demodulation artifacts within the detection bandwidth and in turn to false detections.

If the excess power is "in band", i.e., within the current real-time bandwidth (e.g., 2 GHz) of the deployed wideband receiver, this can be handled by the internal auto ranging facility, which detects an overload of the internal ADC and calculates an appropriate attenuation in the preselector.

However, if the excess power is "out of band", mixing/demodulation artifacts may be generated despite the internal ADC is not overloaded.

### Summary

It is an object to overcome the above-mentioned and other drawbacks.

The foregoing and other objects are achieved by the features of the independent claims. Further implementation forms are apparent from the dependent claims, the description and the figures.

According to a first aspect of the present disclosure, a system for overload detection and prevention in radio spectrum monitoring is provided. The system comprises an antenna, adapted to capture a wideband signal; a first wideband receiver; a second wideband receiver; and a power splitter, adapted to supply the captured wideband signal to the first wideband receiver and to the second wideband receiver. The first wideband receiver is adapted to periodically scan the supplied wideband signal for a highest signal power level and an associated frequency, and to periodically broadcast the highest signal power level and the associated frequency over a packet-switched network. The second wideband receiver is adapted to receive the highest signal power level and the associated frequency over the packet-switched network, to attenuate the supplied wideband signal in accordance with the highest signal power level, the associated frequency, and a limiting signal power level of the wideband receivers, and to receive the attenuated wideband signal.

The limiting signal power level may be between 30 dB and 0 dB lower than an ADC overload power level of the wideband receivers.

The first wideband receiver may further be adapted to periodically scan the supplied wideband signal for a highest signal power level in excess of the limiting signal power level, and an associated frequency.

The first wideband receiver may further be adapted to periodically scan the supplied wideband signal for a highest signal power level and an associated frequency in accordance with a power level hysteresis.

The packet-switched network may comprise a UDP/IP network.

The broadcast may comprise a UDP packet, comprising an identifier of a source of the UDP packet, the highest signal power level, the associated frequency, and a name of the antenna being associated with the highest signal power level.

The second wideband receiver may further be adapted to receive the highest signal power level and the associated frequency over the packet-switched network from the source of the UDP packet if it includes the highest signal power level and the name of the antenna supplying the captured wideband signal to the second wideband receiver.

The second wideband receiver may comprise an adaptive attenuation member, adapted to attenuate the supplied wideband signal in accordance with the highest signal power level, the associated frequency, and the limiting signal power level of the second wideband receiver.

The adaptive attenuation member may comprise a broadband attenuator, adapted to attenuate the supplied wideband signal broadband by at least a difference of the highest signal power level and the limiting signal power level.

The adaptive attenuation member may comprise a frequency-selective notch filter, adapted to attenuate the supplied wideband signal at the associated frequency by at least the difference of the highest signal power level and the limiting signal power level.

The system may further comprise a digital signal processing unit, adapted to analyze the received wideband signal.

The wideband signal may comprise a frequency range between 20 MHz and 300 GHz, and preferably between 500 MHz and 18 GHz.

The received wideband signal may comprise an in-phase/quadrature (IQ or I/Q) signal.

The first wideband receiver and the second wideband receiver may be a single wideband receiver being alternatingly operated as the first wideband receiver and the second wideband receiver.

According to a second aspect of the present disclosure, a method for overload detection and prevention in radio spectrum monitoring is provided. The method comprises capturing a wideband signal; supplying the captured wideband signal to a first wideband receiver and to a second wideband receiver; periodically scanning, by the first wideband receiver, the supplied wideband signal for a highest signal power level and an associated frequency; periodically broadcasting the highest signal power level and the associated frequency over a packet-switched network; receiving, by the second wideband receiver, the highest signal power level and the associated frequency over the packet-switched network; attenuating the supplied wideband signal in accordance with the highest signal power level, the associated frequency, and a limiting signal power level of the wideband receivers; and receiving the attenuated wideband signal.

### Brief Description of Drawings

The above-described aspects and implementations will now be explained with reference to the accompanying drawings, in which the same or similar reference numerals designate the same or similar elements.

The drawings are to be regarded as being schematic representations, and elements illustrated in the drawings are not necessarily shown to scale. Rather, the various elements are represented such that their function and general purpose become apparent to those skilled in the art.
FIG. 1 illustrates a system 1 in accordance with the present disclosure for overload detection and prevention in radio spectrum monitoring; and
FIG. 2 illustrates a corresponding method 2 in accordance with the present disclosure for overload detection and prevention in radio spectrum monitoring.

### Detailed Descriptions of Drawings

In the following description, reference is made to the accompanying drawings, which form part of the disclosure, and which show, by way of illustration, specific aspects of implementations of the present disclosure or specific aspects in which implementations of the present disclosure may be used. It is understood that implementations of the present disclosure may be used in other aspects and comprise structural or logical changes not depicted in the figures. The following detailed description, therefore, is not to be taken in a limiting sense, and the scope of the present disclosure is defined by the appended claims.

For instance, it is understood that a disclosure in connection with a described method may also hold true for a corresponding apparatus or system configured to perform the method and vice versa. For example, if one or a plurality of specific method steps are described, a corresponding device may include one or a plurality of units, e.g. functional units, to perform the described one or plurality of method steps (e.g. one unit performing the one or plurality of steps, or a plurality of units each performing one or more of the plurality of steps), even if such one or more units are not explicitly described or illustrated in the figures. On the other hand, for example, if a specific apparatus is described based on one or a plurality of units, e.g. functional units, a corresponding method may include one step to perform the functionality of the one or plurality of units (e.g. one step performing the functionality of the one or plurality of units, or a plurality of steps each performing the functionality of one or more of the plurality of units), even if such one or plurality of steps are not explicitly described or illustrated in the figures. Further, it is understood that the features of the various exemplary implementations and/or aspects described herein may be combined with each other, unless specifically noted otherwise.

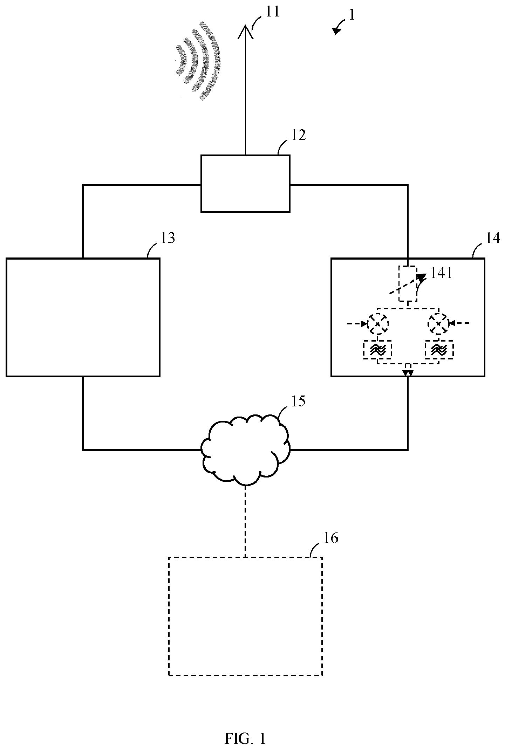

FIG. 1 illustrates a system 1 in accordance with the present disclosure for overload detection and prevention in radio spectrum monitoring.

The system 1 comprises an antenna 11, adapted to capture a wideband signal.

The wideband signal may comprise a frequency range between 20 MHz and 300 GHz, and preferably between 500 MHz and 18 GHz.

The system 1 further comprises a power splitter 12, a first wideband receiver 13, and a second wideband receiver 14. The first and second wideband receivers 13, 14 may respectively comprise a wideband monitoring receiver or a spectrum analyzer, for example.

The power splitter 12 (e.g. a 3 dB power coupler) is adapted to supply the captured wideband signal to the first wideband receiver 13 and to the second wideband receiver 14.

The first wideband receiver 13 is adapted to periodically scan the supplied wideband signal for a highest signal power level (e.g. in 1/10 dBµV) and an associated frequency (e.g. in Hz).

This may include periodically scanning the supplied wideband signal for the highest signal power level in excess of a limiting signal power level of the wideband receivers 13, 14.

Alternatively or additionally, this may include periodically scanning the supplied wideband signal for the highest signal power level in accordance with a power level hysteresis.

A period of the scanning may depend on a scan speed (e.g., up to 2.500 GHz/s) of the deployed first wideband receiver 13.

It is also possible to divide up the frequency spectrum of the supplied wideband signal between multiple first wideband receivers 13, which may result in even more frequent scans of the supplied wideband signal (i.e., smaller period).

The first wideband receiver 13 is further adapted to periodically broadcast the highest signal power level and the associated frequency over a packet-switched network 15, which may comprise a UDP/IP network, to a configurable port.

A period of the broadcast may depend on a loss probability of UDP traffic. For example, the most recent highest signal power level and the associated frequency may be broadcast every 10 sec.

In case of multiple first wideband receivers 13, the respective receiver 13 may be adapted to periodically broadcast the highest signal power level and the associated frequency in its specific part of the frequency spectrum of the supplied wideband signal.

The broadcast may comprise a UDP packet, comprising an identifier of a source of the UDP packet, the highest signal power level, the associated frequency, and a name of the antenna 11 being associated with the highest signal power level.

The second wideband receiver 14 is adapted to receive the highest signal power level and the associated frequency being disseminated by the first wideband receiver 13 over the packet-switched network 15.

This may include receiving the highest signal power level and the associated frequency over the packet-switched network 15 from the source of the UDP packet if the received UDP packet includes the highest signal power level and the name of the antenna 11 supplying the captured wideband signal to the second wideband receiver 14. This ensures that the communicating first and second wideband receivers 13, 14 are supplied by the same antenna 11.

The second wideband receiver 14 is further adapted to attenuate the supplied wideband signal in accordance with the received highest signal power level, the associated frequency, and the limiting signal power level of the wideband receivers 13, 14.

To this end, the second wideband receiver 14 may comprise an adaptive attenuation member 141.

The adaptive attenuation member 141 may comprise a broadband attenuator, adapted to attenuate the supplied wideband signal broadband by at least a difference of the highest signal power level and the limiting signal power level.

Alternatively, the adaptive attenuation member 141 may comprise a frequency-selective notch filter, adapted to attenuate the supplied wideband signal at the associated frequency by at least the difference of the highest signal power level and the limiting signal power level.

According to both implementations, a power level of the supplied wideband signal at the associated frequency will be lower or equal to the limiting signal power level.

In particular, the limiting signal power level may be between 30 dB and 0 dB lower than an overload power level of an analog-digital converter, ADC (not shown), of the wideband receivers 13, 14. This ensures that mixing artefacts arising and leading to false detections well before the ADC is overloaded are avoided.

The second wideband receiver 14 is thus adapted to receive the attenuated wideband signal, thereby avoiding false detections.

The received wideband signal may comprise an in-phase/quadrature, IQ, signal.

The system 1 may further comprise a digital signal processing unit 16, adapted to analyze the received wideband signal.

The digital signal processing unit 16 may facilitate a characterization and analysis of the received wideband signal, especially in terms of a type, location, mobility and/or activity pattern of the source of the wideband signal, for example.

According to an implementation, the first wideband receiver 13 and the second wideband receiver 14 may be a same/single wideband receiver 13, 14 which is alternatingly operated as the first wideband receiver 13 and the second wideband receiver 14. Note that the wideband receiver 13, 14 is not able to scan *and* attenuate/receive the supplied wideband signal concurrently.

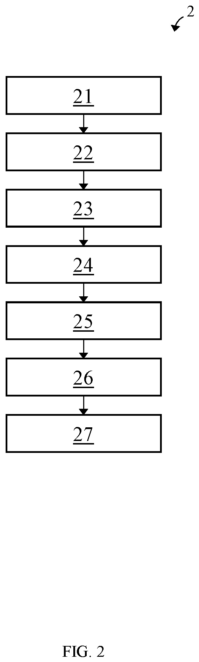

FIG. 2 illustrates a corresponding method 2 in accordance with the present disclosure for overload detection and prevention in radio spectrum monitoring.

The method 2 comprises a step of capturing 21 a wideband signal.

The method 2 further comprises a step of supplying 22 the captured wideband signal to a first wideband receiver 13 and to a second wideband receiver 14.

The method 2 further comprises a step of periodically scanning 23, by the first wideband receiver 13, the supplied wideband signal for a highest signal power level and an associated frequency.

The method 2 further comprises a step of periodically broadcasting 24 the highest signal power level and the associated frequency over a packet-switched network 15.

The method 2 further comprises a step of receiving 25, by the second wideband receiver 14, the highest signal power level and the associated frequency over the packet-switched network 15.

The method 2 further comprises a step of attenuating 26 the supplied wideband signal in accordance with the highest signal power level, the associated frequency, and a limiting signal power level of the wideband receivers 13, 14.

The method 2 further comprises a step of receiving 27 the attenuated wideband signal.

In a nutshell, the idea to overcome false detections is to use the first wideband receiver 13 to detect excessive out-of-band signals in the whole frequency range of the wideband signal and to use the second wideband receiver 14 to set its preselector attenuator accordingly and receive the appropriately attenuated wideband signal.

The present disclosure has been described in conjunction with various implementations as examples. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation. A computer program may be stored/distributed on a suitable medium, such as an optical storage medium or a solid-state medium supplied together with or as part of other hardware, but may also be distributed in other forms, such as via the Internet or other wired or wireless telecommunication systems.

## Claims

1. A system (1) for overload detection and prevention in radio spectrum monitoring, the system (1) comprising
an antenna (11), adapted to
- capture a wideband signal;
a power splitter (12), adapted to
- supply the captured wideband signal to a first wideband receiver (13) and to a second wideband receiver (14);
the first wideband receiver (13), adapted to
- periodically scan the supplied wideband signal for a highest signal power level and an associated frequency; and
- periodically broadcast the highest signal power level and the associated frequency over a packet-switched network (15); and
the second wideband receiver (14), adapted to
- receive the highest signal power level and the associated frequency over the packet-switched network (15);
- attenuate the supplied wideband signal in accordance with the highest signal power level, the associated frequency, and a limiting signal power level of the wideband receivers (13, 14); and
- receive the attenuated wideband signal.

2. The system (1) of claim 1,
the limiting signal power level being between 30 dB and 0 dB lower than an ADC overload power level of the wideband receivers (13, 14).

3. The system (1) of claim 1 or claim 2,
the first wideband receiver (13) further being adapted to
- periodically scan the supplied wideband signal for a highest signal power level in excess of the limiting signal power level, and an associated frequency.

4. The system (1) of any one of the claims 1 to 3,
the first wideband receiver (13) further being adapted to
- periodically scan the supplied wideband signal for a highest signal power level and an associated frequency in accordance with a power level hysteresis.

5. The system (1) of any one of the claims 1 to 4,
the packet-switched network (15) comprising
a UDP/IP network.

6. The system (1) of claim 5,
the broadcast comprising
a UDP packet, comprising
an identifier of a source of the UDP packet,
the highest signal power level,
the associated frequency, and
a name of the antenna (11) being associated with the highest signal power level.

7. The system (1) of claim 6,
the second wideband receiver (14) further being adapted to
- receive the highest signal power level and the associated frequency over the packet-switched network (15) from the source of the UDP packet if it includes the highest signal power level and the name of the antenna (11) supplying the captured wideband signal to the second wideband receiver (14).

8. The system (1) of any one of the claims 1 to 7,
the second wideband receiver (14) comprising
an adaptive attenuation member (141), adapted to
- attenuate the supplied wideband signal in accordance with the highest signal power level, the associated frequency, and the limiting signal power level of the second wideband receiver (14).

9. The system (1) of claim 8,
the adaptive attenuation member (141) comprising
a broadband attenuator, adapted to
- attenuate the supplied wideband signal broadband by at least a difference of the highest signal power level and the limiting signal power level.

10. The system (1) of claim 8,
the adaptive attenuation member (141) comprising
a frequency-selective notch filter, adapted to
- attenuate the supplied wideband signal at the associated frequency by at least the difference of the highest signal power level and the limiting signal power level.

11. The system (1) of any one of the claims 1 to 10, further comprising a digital signal processing unit (16), adapted to
- analyse the received wideband signal.

12. The system (1) of any one of the claims 1 to 11,
the wideband signal comprising a frequency range
between 20 MHz and 300 GHz, and preferably
between 500 MHz and 18 GHz.

13. The system (1) of any one of the claims 1 to 12,
the received wideband signal comprising an in-phase/quadrature, IQ, signal.

14. The system (1) of any one of the claims 1 to 13,
the first wideband receiver (13) and the second wideband receiver (14) being a single wideband receiver (13, 14) being alternatingly operated as the first wideband receiver (13) and the second wideband receiver (14).

15. A method (2) for overload detection and prevention in radio spectrum monitoring, the method (2) comprising
- capturing (21) a wideband signal;
- supplying (22) the captured wideband signal to a first wideband receiver (13) and to a second wideband receiver (14);
- periodically scanning (23), by the first wideband receiver (13), the supplied wideband signal for a highest signal power level and an associated frequency;
- periodically broadcasting (24) the highest signal power level and the associated frequency over a packet-switched network (15);
- receiving (25), by the second wideband receiver (14), the highest signal power level and the associated frequency over the packet-switched network (15);
- attenuating (26) the supplied wideband signal in accordance with the highest signal power level, the associated frequency, and a limiting signal power level of the wideband receivers (13, 14); and
- receiving (27) the attenuated wideband signal.
